(19) Europäisches Patentamt
European Patent Office
Office européen des brevets

(11) EP 0 432 622 B1

(12) EUROPÄISCHE PATENTSCHRIFT

(45) Veröffentlichungstag und Bekanntmachung des Hinweises auf die Patenterteilung:
**27.03.1996 Patentblatt 1996/13**

(51) Int Cl.$^6$: **G03F 7/32**

(21) Anmeldenummer: **90123289.2**

(22) Anmeldetag: **05.12.1990**

# (54) Verfahren zum Entwickeln von Photoresisten

Process for developing photoresists

Procédé pour développer des photoréserves

(84) Benannte Vertragsstaaten:
**BE DE FR GB IT NL**

(30) Priorität: **15.12.1989 DE 3941394**

(43) Veröffentlichungstag der Anmeldung:
**19.06.1991 Patentblatt 1991/25**

(73) Patentinhaber: **BASF Aktiengesellschaft**
**D-67063 Ludwigshafen (DE)**

(72) Erfinder:
- **Binder, Horst**
  **W-6840 Lampertheim (DE)**
- **Schwalm, Reinhold, Dr.**
  **W-6706 Wachenheim (DE)**

(56) Entgegenhaltungen:
**EP-A- 0 286 272** **DE-A- 3 927 693**
**GB-A- 2 193 335**

- **PATENT ABSTRACTS OF JAPAN vol. 6, no. 209 (P-150)(1087) 21. Oktober 1982 & JP- A-57 114 141**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 432 622 B1

**Beschreibung**

Die Erfindung betrifft ein Verfahren zum Entwickeln von positiv arbeitenden Photoresisten mit einem wäßrigen, basische organische Verbindungen enthaltenden Entwicklersystem, wobei die wäßrigen Lösungen Kombinationen bestimmter basischer organischer Verbindungen enthalten.

Zur selektiven Veränderung von kleinen Bereichen in einem Substrat verwendet man in der Halbleitertechnik Photoresiste als Hilfsschicht. Dazu werden bevorzugt positiv arbeitende Photoresiste eingesetzt. Mit Hilfe der Photoresiste lassen sich Reliefmuster herstellen, die an bestimmten Stellen die zu verändernde Oberfläche freilegen und sie damit weiterer Behandlung, wie Dotierung oder Metallisierung zugänglich machen.

Positiv-Resistmuster werden erzeugt, indem eine Schicht eines lichtempfindlichen Materials auf einem Siliziumwafer aufgebracht, anschließend durch eine strukturierte Maske belichtet und im Entwicklungsprozeß die belichteten Bereiche selektiv herausgelöst werden.

Übliche lichtempfindliche Zusammensetzungen sind solche aus alkalilöslichen Harzen, z.B. vom Novolaktyp, und einer photoempfindlichen Komponente, beispielsweise einem o-Chinondiazid. Durch die Einwirkung von UV-Licht wird die Löslichkeit der Zusammensetzung in alkalischen Entwicklern in den belichteten Bereichen drastisch erhöht.

Entwickler für Photoresiste auf Basis von Novolaken sind bereits bekannt. Diese enthalten im allgemeinen Natriumsilikate, Natriumphosphate, Natrium- bzw. Kaliumhydroxid und Tenside. Aus der EP-A-146 834 bzw. der EP-A-231 028 sind auch bereits Entwicklerlösungen bekannt, die Kombinationen aus quaternären Ammoniumtensiden und Ammoniumhydroxiden bzw. halogenierten (fluorierten) nichtionischen Tensiden und Alkalihydroxidentwicklern enthalten. Diese Entwicklerlösungen ergeben zwar einen guten Kontrast, weisen jedoch nur eine begrenzte Stabilität und eine limitierte Entwicklungskapazität sowie ungenügende Reproduzierbarkeit bei der Tauchentwicklung auf, da die Tenside schnell verbraucht werden.

Der EP-A-124 297 sind metallionenfreie Entwickler zu entnehmen, die Tetraalkylammoniumhydroxide, wie z.B. Tetramethylammoniumhydroxid, Tetraethylammoniumhydroxid oder Kombinationen verschiedener Tetraalkylammoniumhydroxide, sowie Zusätze von Entwicklermodifizierungsmittel, wie z.B. ein wasserlösliches aliphatisches Keton, einen cyclischen Ether oder ein tertiäres Amin, in einer Menge von 5 - 1000 ppm enthalten. Als weitere Zusätze sind hier auch wasserlösliche primäre Amine mit 1 oder 2 C-Atomen oder sekundäre Amine mit 2 bis 5 C-Atomen in Mengen von 5 bis 500 ppm, wie z.B. Monomethylamin, Monoethylamin, Dimethylamin, Piperazine und Piperidine erwähnt. Nachteilig bei diesen Systemen ist, daß man mit ihnen einen schlechten Kontrast und hohen Photolackabtrag in den nichtbelichteten Bildbereichen erhält.

Die Entwicklung von Photoresisten, die Chinondiazidgruppen enthaltende Verbindungen als unter Bestrahlung säurebildende Komponente enthalten, wird in EP-A-0 286 272, JP-A-57-114 141, GB-A-2 193 335 und DE-A-3 927 693 beschrieben.

Aufgabe der vorliegenden Erfindung ist es, ein Verfahren zum Entwickeln positiv arbeitender Photoresiste mittels eines wäßrig-al-kalischen Entwicklers aufzuzeigen, der sowohl den unbelichteten Resist nicht angreift als auch einen hohen Kontrast ermöglicht und genügende Lagerstabilität besitzt.

Ferner soll das Entwicklermedium folgende Kriterien erfüllen: der Entwickler darf keine Metallionen enthalten, er muß sich nach der Entwicklung vollständig entfernen lassen, typische Substratoberflächen, wie aufgedampftes Aluminium, dürfen nicht angegriffen werden, auch sollte der Surface-Peeling-Effekt, also das Ablösen einer dünnen Lackhaut, unterdrückt werden.

Dies läßt sich überraschenderweise besonders vorteilhaft durch das erfindungsgemäße Verfahren erreichen.

Gegenstand der vorliegenden Erfindung ist ein Verfahren zum Entwickeln positiv arbeitender Resiste, die als strahlungsempfindliche Schicht ein Gemisch aus mindestens einem phenolischen Polymeren und mindestens einem Sulfoniumsalz mit säurelabilen Gruppen enthalten, wobei die strahlungsempfindliche Schicht nach der bildmäßigen Bestrahlung mit einer wäßrigen, basische organische Verbindungen enthaltenden Entwicklerlösung entwickelt wird, die 0,3 bis 5 Gew.-% eines Tetraalkylammoniumhydroxids mit 1 bis 3 Kohlenstoffatomen in der, gegebenenfalls hydroxylsubstituierten, Alkylgruppe und 3 bis 30 Gew.-% mindestens eines Amins der allgemeinen Formel (I)

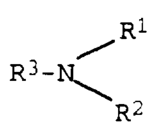

(I),

worin $R^1$, $R^2$ und $R^3$ untereinander gleich oder verschieden sind und für Wasserstoff, Alkyl mit 1 bis 3 Kohlenstoffatomen, Hydroxyalkyl mit 2 oder 3 Kohlenstoffatomen, Aminoalkyl mit 2 oder 3 Kohlenstoffatomen stehen oder zwei der Reste $R^1$ bis $R^3$ miteinander zu einem 5- bis 7-gliedrigen N-haltigen Ring verknüpft sind, mit der Maßgabe, daß mindestens einer der Reste $R^1$ bis $R^3$ Hydroxylalkyl oder Aminoalkyl ist, enthält.

Die erfindungsgemäß einzusetzenden Entwicklerlösungen können auch zusätzlich bis zu 5 Gew.-% eines 2 oder 4 Kohlenstoffatome enthaltenden Alkohols oder eines wasserlöslichen Glykolethers enthalten.

Die erfindungsgemäß einzusetzenden Entwicklerlösungen können auch Gemische der Amine der allgemeinen Formel (I) enthalten.

Bevorzugt enthalten die erfindungsgemäß zu verwendenden wäßrigen Entwicklerlösungen als Amin der allgemeinen Formel (I) Diethanolamin, N-Methyldiethanolamin, Triethanolamin, ein Aminopropanol, 3-Amino-1-propylamin, 3-Dimethylamino-1-propylamin oder ein N-Hydroxyalkylpiperidin.

Die erfindungsgemäß einzusetzenden Entwicklerlösungen für Positivresiste auf Basis einer wäßrigen Lösung bestimmter Mengen organischer Amine der allgemeinen Formel (I) und Tetramethylammoniumhydroxid bzw. Tetraethylammoniumhydroxid weisen ausgezeichnete Entwicklereigenschaften auf.

Die erfindungsgemäß zu verwendende Entwicklerlösung enthält im allgemeinen 3 bis 30 Gew.-%, vorzugsweise 5 bis 20 Gew.-%, bezogen auf die Gesamtmenge der Entwicklerlösung eines Amins der allgemeinen Formel (I) und 0,3 bis 5, vorzugsweise 1,0 bis 2,0 Gew.-% Tetraalkylammoniumhydroxid.

Als weiteres Entwicklungsmodifizierungsmittel können 0,3 bis 5 Gew.-% Alkohole, wie Isopropanol, 1,2-Propandiol, Ethanol oder eines wasserlöslichen Glykolethers, wie z.B. Butylglykol zugesetzt werden. Derartige Zusätze führen im allgemeinen zu einer Erhöhung der Abtragsgeschwindigkeit des belichteten Photolackes und können Ablagerungen von Verunreinigungen verhindern.

Ein Zusatz von oberflächenaktiven Substanzen (Tensiden) zur erfindungsgemäßen Entwicklerlösung ist im allgemeinen nicht nötig. Es können jedoch derartige Stoffe im allgemeinen in Mengen von bis zu 5 Gew.-%, bezogen auf Gesamtmenge der Entwicklerlösung, beispielsweise Nonylphenoxypoly-(ethylenoxi)ethanol, Octylphenoxy-poly-(ethylenoxi)ethanol oder kommerziell erhältliche fluorierte Tenside zugesetzt werden.

Besonders geeignet ist das erfindungsgemäße Verfahren für Positivresiste basierend auf den in DE-A 3 721 741 beschriebenen Systemen aus phenolischen Polymeren und Oniumsalzen mit säurelabilen Gruppen. Bevorzugte Oniumsalze sind dabei Sulfoniumsalze der allgemeinen Formel (II):

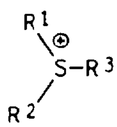 $X^{\ominus}$ (II),

worin $R^1$ bis $R^3$ untereinander gleich oder verschieden sind und aromatische und/oder aliphatische Reste, die gegebenenfalls Heteroatome enthalten, enthalten können, mit der Maßgabe, daß mindestens einer der Reste $R^1$ bis $R^3$ eine säurespaltbare Gruppe, beispielsweise t-Butylcarbonate von Phenolen bzw. Silylether von Phenolen, enthält. Die vorgenannten säurelabilen Gruppen sind bevorzugt, jedoch können eine große Zahl weiterer säurelabiler Gruppen, wie die bekannten Tetrahydropyranylether, Orthoester, Trityl- und Benzylgruppen, sowie t-Butylester von Carbonsäuren ebenfalls verwendet werden. Es können auch zwei oder mehrere Sulfoniumeinheiten im Molekül über die Reste $R^1$ bis $R^3$ verknüpft sein.

Als Gegenionen $X^{\ominus}$ kommen bevorzugt komplexe Metallhalogenide, wie Tetrafluorborat, Hexafluoroantimonat, Hexafluoroarsenat, Hexafluorophosphat und Triflat ($CF_3SO_3^{\ominus}$) in Betracht.

Das phenolische Polymere enthält im allgemeinen Einheiten der allgemeinen Formel (III):

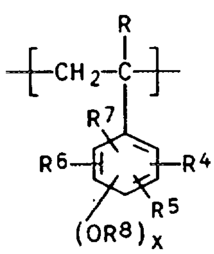 (III),

worin R ein Wasserstoff- oder Halogenatom oder eine Alkylgruppe mit 1 bis 4 Kohlenstoffatomen, $R^4$, $R^5$, $R^6$, $R^7$ Wasserstoff-, Halogen, Alkyl- oder Alkoxigruppen mit jeweils 1 bis 4 Kohlenstoffatomen, $R^8$ Wasserstoff oder eine säurelabile Gruppe, wie Trimethylsilyl, t-Butoxycarbonyl, Isopropyloxicarbonyl oder Tetrahydropyranyl bedeuten und x eine Zahl von 1 bis 3, vorzugsweise 1 ist.

Bevorzugt sind solche Polymerisate der Formel (III), bei der R Wasserstoff oder Methyl ist, sowie $R^4$ bis $R^7$ Wasserstoff und $R^8$ Wasserstoff und/oder eine säurelabile Gruppe der vorgenannten Bedeutung ist, wobei -O-$R^8$ in p-Stellung steht und der Anteil der Gruppen mit $R^8$ = Wasserstoff mindestens 70 mol% beträgt.

Diese Polymeren haben im allgemeinen mittlere Molekulargewichte ($\overline{M}_n$) im Bereich von 1 000 bis 250 000, bevorzugt 10 000 bis 80 000 und sind im allgemeinen mit einem Anteil zwischen 40 und 98, vorzugsweise 60 bis 95 Gew.% im strahlungsempfindlichen Gemisch enthalten.

Als polymere Bindemittel können auch Gemische alkalisch löslicher Polymerer eingesetzt werden, die einen hohen Anteil aromatischer Gruppen enthalten, nämlich Gemische aus Novolake und substituierte Poly-(p-hydroxystyrole). Bindemittel mit einem hohen aromatischen Anteil haben den Vorteil, daß sie relativ stabil in Plasma- und reaktiven Ionenstrahlätzverfahren sind.

Das erfindungsgemäße Verfahren zur Erzeugung von Reliefmustern wird in bekannter Weise durchgeführt, jedoch unter Verwendung des erfindungsgemäßen Entwicklers. Dazu werden die Gemische aus phenolischem Harz und/oder phenolischem Polymerisat und photoempfindlicher Komponente im allgemeinen in einem organischen Lösungsmittel gelöst, wobei der Feststoffgehalt im Bereich zwischen 5 und 40, insbesondere 10 und 30 Gew.% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethyl-cellosolve, Butylglykol, Methyl-cellosolve und 1-Methoxy-2-propanol, Alkylenglykolalkylether-ester, wie beispielsweise Methyl-cellosolve-acetat, Ethylcellosolve-acetat, Methyl-propylen-glykol-acetat und Ethyl-propylen-glykol-acetat, Ketone, wie beispielsweise Cyclohexanon, Cyclopentanon und Methyl-ethyl-keton, sowie Acetate, wie Butylacetat und Aromaten, wie Toluol und Xylol. Die Auswahl der entsprechenden Lösungsmittel, sowie deren Mischung richtet sich nach der Wahl des jeweiligen phenolischen Polymers und der photoempfindlichen Komponente.

Weiterhin können andere Zusätze wie Haftvermittler, Netzmittel, Farbstoffe und Weichmacher zugesetzt werden.

Gegebenenfalls können auch Sensibilisatoren in geringen Mengen zugesetzt werden, um die Verbindungen im längerwelligem UV- bis hin zum sichtbaren Bereich zu sensibilisieren. Polycyclische Aromaten, wie Pyren und Perylen sind bevorzugt, jedoch können auch andere Farbstoffe, die als Sensibilisatoren wirken, verwendet werden.

Die homogene Lösung des lichtempfindlichen Gemisches kann durch einen Filter mit einem Porendurchmesser von ca. 0,2 µm filtriert und in üblicher weise, beispielsweise durch Aufschleudern (spin coating) zwischen 2000 und 10 000 U/min. auf das zu beschichtende Substrat - im allgemeinen auf einen an der Oberfläche oxidierten Siliziumwafer - aufgetragen werden, so daß eine lichtempfindliche Schicht in einer Schichtdicke von ca. 1 - 2 µm erhalten wird, wobei im allgemeinen zwischen 1 und 10 Minuten bei Temperaturen zwischen 80°C und 100°C ausgeheizt wird. Durch bildmäßige Belichtung mit Hilfe einer strukturierten Maske, z.B. bei der optischen Lithographie durch eine chrombeschichtete strukturierte Quarzmaske, wobei als Lichtquellen beispielsweise UV-Licht von Quecksilber-Hochdrucklampen, Cadmium-Xenon-Lampen oder Excimer-Laserstrahlung in Frage kommen, erzeugt man in der lichtempfindlichen Schicht ein latentes Bild. Für die Belichtung kommen auch Röntgen- und Elektronenstrahlen in Frage. Vor dem Entwicklungsschritt sollte bei den Systemen auf Basis von Poly-(p-hydroxystyrol)/Sulfoniumsalz noch ein weiteres Ausheizen (postexposure-bake) bei Temperaturen zwischen 60°C und 120°C zwischen etwa 5 Sekunden und 4 Minuten erfolgen. Durch Kontaktieren der so behandelten lichtempfindlichen Schicht mit dem erfindungsgemäß eingesetzten Entwickler, entweder durch Eintauchen in die Entwicklerlösung oder durch Besprühen mit Entwickler wird das latente Bild zu einem Reliefmuster entwickelt, wobei sich die belichteten Bereiche selektiv auflösen, während in den unbelichteten Bereichen nur wenig Abtrag stattfindet. Nach dem Behandeln mit der erfindungsgemäßen Entwicklerlösung wird das erzeugte Relief getrocknet und dient dann als Maske für die weiteren Behandlungsschritte, wie z.B. Ätzen des Substrats.

Nach dem Entwicklungsprozeß wurde die Photosensitivität, der Gammawert und das Abtragsverhältnis der Filme bestimmt. Für Positiv-Resistsysteme ist der Gamma-Wert definiert als

$$\Gamma_p = \left[\log \frac{D_1}{D_0}\right]^{-1},$$

wobei $D_0$ und $D_1$ die extrapolierten Belichtungsenergiedosen aus der Dunkelabtrags-Energiekurve darstellen.

Die Schichtdicken der Polymerfilme wurden mit einem α-Step-Profilometer der Firme Tencor oder einem Interferometer der Fa. Leitz gemessen.

Der im erfindungsgemäßen Verfahren eingesetzte Entwickler zeigt sehr gute Eigenschaften in bezug auf die zu erzielende Auflösung (kleiner 0,7 µm) und Kantensteilheit. Er verfügt über gute Entwicklungskapazität und ist lagerstabil.

Nach dem Spülen mit deionisiertem Wasser konnten keinerlei unerwünschte Rückstände bzw. Ablagerungen auf den Photoresistpattern oder den freientwickelten Stellen des Wafers nachgewiesen werden.

Die in den Beispielen angegebenen Teile und Prozente sind, soweit nicht anders angegeben, Gewichtsteile und Gewichtsprozente.

Beispiel 1

Eine Photoresistlösung, bestehend im wesentlichen aus 16 Teilen eines Poly(p-hydroxistyrols) mit einem mittleren Molekulargewicht von 25000 ($\overline{M}_n$ aus GPC) als alkalilöslichem Bindemittel aus 5 Teilen Tris-(4-t-butoxicarbonyl-oxiphenyl)-sulfoniumhexafluoroarsenat als photoaktiver Komponente und 80 Teilen Methyl-propylenglycol-acetat als Lösungsmittel, wird in einer Schichtdicke von 1,0 µm auf einem thermisch oxidierten Siliziumwafer aufgetragen und 1 Minute bei 90°C ausgeheizt. Die Belichtung der so vorbehandelten Substrate erfolgte mit kurzwelligem UV-Licht der Wellenlänge 248 nm. Nach einer thermischen Nachbehandlung von 1 Minute bei 90°C konnte der so behandelte Siliziumwafer in den verschiedenen Entwicklerformulierungen entwickelt werden.

Die rasterelektronemikroskopische Untersuchungen der Photoresiststrukturen ergab, daß Strukturen mit einer Breite von 0,5 µm sauber ausentwickelt sind. Die untersuchten Strukturen zeigen fast 90° Flanken. Die Oberfläche in den unbelichteten Bereichen ist nach der Entwicklung völlig glatt und transparent, d.h. ein ungleichmäßiger Abtrag des unbelichteten Resistes findet nicht statt.

Die Ergebnisse der Untersuchung sind in Tabelle 1 zusammengefaßt.

Tabelle 1

Die wäßrige Entwicklerlösung enthält:

| % N-(2-Hydroxy-ethyl)piperidin | % Butyl-glycol | % TMAH | Empfindlichkeit [mJ/cm2] | Ergebnisse % Rest-schicht | $\Gamma_p$ |
|---|---|---|---|---|---|
| 5 | 2 | 2,0 | 18 | 11 | 1,5 |
| 5 | 2 | 1,8 | 21 | 7 | 3,1 |
| 5 | 2 | 1,6 | 22 | 1,5 | 3,3 |
| 5 | 2 | 1,4 | 26 | 0,1 | 3,2 |
| 10 | 2 | 1,4 | 20 | 5 | 5,0 |

TMAH = Tetramethylammoniumhydroxid

Beispiel 2

Ein Positiv-Photoresist-Lack auf Basis eines Poly(p-hydroxystyrols) und einem Sulfoniumsalz sowie Methyl-propylenglycol-acetat als Lösungsmittel wird mit einer Schichtdicke von 1,5 µm auf einem oxidierten Siliziumwafer aufgetragen und anschließend 1 Minute bei 90°C auf einer Heizplatte ausgeheizt.

Nach der Belichtung mit Excimerlicht der Wellenlänge 248 nm wird der Wafer dem für diese Photosysteme üblichen Temperaturprozeß von 1 Minute bei 90°C unterworfen und anschließend entwickelt. Nach der Entwicklung werden die Resiststrukturen auf dem Siliziumwafer beurteilt und die verbleibende Restschichtdicke mit einem α-Step-Profilometer ausgemessen.

Die Ergebnisse sind in der Tabelle 2 aufgeführt.

Tabelle 2

| Die wäßrige Entwicklerlösung enthält: | | | | |
|---|---|---|---|---|
| | | | Ergebnisse | |
| % Methyldiethanolamin | % TMAH | Empfindlichkeit [mJ/cm2] | % Restschicht | $\Gamma_p$ |
| 15 | 1,0 | 70 | 0 | 6,8 |
| 15 | 1,5 | 33 | 3 | 9,6 |
| 5 | 1,5 | 50 | 0 | 11 |
| 10 | 1,5 | 50 | 1 | 10 |
| 20 | 1,5 | 55 | 3 | 3,4 |

Beispiel 3

Ein Photoresistsystem wird entsprechend Beispiel 2 vorbehandelt. Die so präparierten Siliziumoxidwafer werden dann in den Entwicklerformulierungen gemäß Tabelle 3 strukturiert.

Die rasterelektronenmikroskopische Untersuchung zeigt, daß Pattern mit einer Linienbreite von kleiner 0,5 µm sehr gut ausentwickelt sind.

Tabelle 3

| Die wäßrige Entwicklerlösung enthält: | | | | |
|---|---|---|---|---|
| | | | Ergebnisse | |
| % 3-Dimethylamino-1-propylamin | % TMAH | Empfindlichkeit [mJ/cm$^2$] | % Restschicht | $\Gamma_p$ |
| 5 | 1,0 | 58 | 0 | 4,1 |
| 10 | 1,0 | 50 | 5 | 4,1 |
| 15 | 1,0 | 42 | 13 | 5,7 |

Bei dem Entwicklersystem, bestehend aus 1,0 % Tetramethylammoniumhydroxid und 5 % 3-Dimethylamino-1-propylamin, werden nach der Entwicklung und dem Reinigungsprozeß mit deionisiertem Wasser folgende Restschichtdikken mit einem Interferometer ausgemessen:

| Belichtungsenergie [mJ/cm$^2$] | Restschicht [%] |
|---|---|
| 2,10 | 100 |
| 9,10 | 100 |
| 18,20 | 100 |
| 29,4 | 100 |
| 37,28 | 75,4 |
| 41,83 | 58,9 |
| 47,1 | 20,9 |
| 66,5 | 0 |
| 76 | 0 |
| 112 | 0 |

Beispiel 4

Das entsprechend Beispiel 2 behandelte Photoresistsystem ergab nach der photolithographischen Strukturierung und Entwicklung in einer Lösung bestehend aus 1,0 % Tetramethylammoniumhydroxid und 5 % N-(2-Hydroxyethyl) piperidin folgende Restschichtdicken:

| Belichtungsenergie [mJ/cm$^2$] | Restschicht [%] |
|---|---|
| 2,10 | 100 |
| 9,10 | 100 |
| 25,2 | 100 |
| 29,4 | 94,7 |
| 33,3 | 78,7 |
| 37,28 | 50,4 |
| 41,83 | 33,6 |
| 47,08 | 13,7 |
| 66,5 | 0 |
| 76 | 0 |
| 83 | 0 |

Weitere Ergebnisse sind in der Tabelle 4 dokumentiert:

Tabelle 4

| Die wäßrige Entwicklerlösung enthält: | | | | |
|---|---|---|---|---|
| | | | Ergebnisse | |
| % N-(2-Hydroxyethyl)piperidin | % TMAH | Empfindlichkeit [$mJ/cm^2$] | % Restschicht | $\Gamma_p$ |
| 5 | 1,0 | 52 | 0 | 3,7 |
| 10 | 1,0 | 47 | 9 | 4,4 |
| 15 | 1,0 | 47 | 12 | 3,9 |
| 15 | 0,5 | 50 | 3 | 4,5 |

Beispiel 5

Auch das Entwicklersystem bestehend aus 2 % Tetramethylammoniumhydroxid und 3-Amino-1-propylamin liefert sehr gute Resultate. Auch hier wurden nach der Entwicklung keine störenden Ablagerungen auf den strukturierten Wafern nachgewiesen. Besonders geeignet ist eine Mischung aus 2,0 % Tetramethylammoniumhydroxid und 10 % 3-Amino-1-propylamin. Bei Verwendung dieser Formulierung werden mit dem Profilometer folgende Restschichtdicken gemessen:

| Belichtungsenergie [$mJ/cm^2$] | Restschicht [%] |
|---|---|
| 2,1 | 98,4 |
| 18,2 | 97,5 |
| 29,4 | 79,8 |
| 33,3 | 61,4 |
| 41,83 | 32,8 |
| 47,01 | 15,1 |
| 56,53 | 0 |
| 66,5 | 0 |
| 76 | 0 |

Weitere Ergebnisse dieser Entwicklerformulierungen sind in der Tabelle 5 aufgeführt.

Tabelle 5

| Die wäßrige Entwicklerlösung enthält: | | | | |
|---|---|---|---|---|
| | | | Ergebnisse | |
| % 3-Amino-1-propylamin | % TMAH | Empfindlichkeit | % Restschicht | $\Gamma_p$ |
| 10 | 2,0 | 54 | 0,7 | 3,3 |
| 15 | 2,0 | 52 | 12 | 3,5 |
| 20 | 2,0 | 48 | 28 | 2,9 |

Beispiel 6

Das entsprechende Beispiel 1 hergestellte Photoresistsystem wird in einer Entwicklerlösung, bestehend aus 1,5 % Tetramethylammoniumhydroxid, 5 % Triethanolamin und 3 % Butylglycol 1 Minute in einem Tauchbad bei 21°C entwikkelt.

Nach dem Reinigungsprozeß mit deionisiertem Wasser werden folgende Restschichtdicken mit dem Profilometer gemessen:

| Belichtungsenergie [$mJ/cm^2$] | Restschicht [%] |
|---|---|
| 2,1 | 100 |
| 9,1 | 100 |

Fortsetzung der Tabelle auf der nächsten Seite

(fortgesetzt)

| Belichtungsenergie [mJ/cm²] | Restschicht [%] |
|---|---|
| 18,2 | 100 |
| 22,4 | 100 |
| 25,2 | 100 |
| 37,2 | 98,3 |
| 47,1 | 95,5 |
| 56,5 | 78,5 |
| 66,5 | 53,77 |
| 94 | 0 |
| 112 | 0 |

Der Schichtabtrag in den unbelichteten Photoresistbereichen durch diesen Entwickler ist kaum meßbar und die Oberfläche nach der Entwicklung ist völlig glatt. Der Kontrast, der mit dieser Formulierung erzielt wird, ist unerwartet hoch; er beträgt 5,7. Durch Erhöhung der Butylglycolkonzentration kann der Gammawert weiter erhöht werden, allerdings wird dann auch der unbelichtete Photoresist unerwünscht angegriffen.

Vergleichsbeispiel

Ein Positiv-Photoresist-Lack wird zunächst entsprechend Beispiel 2 behandelt. Nach der Belichtung mit Excimerlicht der Wellenlänge 248 nm und der thermischen Nachbehandlung werden die Wafer in einer 2,0 %igen Tetramethylammoniumhydroxid-Lösung ohne Zusatz von Aminen und einer 2,0 %igen Entwicklerlösung mit Aminzusatz getaucht.

Die Ergebnisse sind in der Tabelle aufgeführt:

| | Schichtdicke [µm] nach der Entwicklung mit | |
|---|---|---|
| Belichtungsenergie [mJ/cm²] | 2,0 % TMAH (= Vergleich) | 2,0 % TMAH + 10 % Methyldiethanolamin (= erfindungsgemäß) |
| 1,26 | 1,51 | 1,50 |
| 5,5 | 1,51 | 1,50 |
| 11,0 | 1,50 | 1,46 |
| 13,4 | 1,46 | 1,16 |
| 15,11 | 1,46 | 0,61 |
| 22,41 | 1,35 | 0,37 |
| 25,1 | 1,35 | 0 |
| 28,0 | sehr schlechte | 0 |
| 45,0 | Haftung,Testfelder nicht meßbar | 0 |

Nach einer Entwicklung mit einer 2,0 %igen Tetramethylammoniumhydroxid-Lösung sind keine vollständig entwickelten Reliefstrukturen erhältlich. Auf dem Resistbild und auf dem freientwickelten Substrat sind Resistablagerungen nachweisbar. Ferner ist feststellbar, daß Entwicklerlösungen ohne Aminzusatz die Resisthaftung negativ beeinflussen.

Werden zu der 2,0 %igen Tetramethylammoniumhydroxid-Lösung etwa 10 % Amin, wie z.B. Methyldiethanolamin, zugesetzt, verändern sich die Entwicklereigenschaften. Das Flankenprofil der Strukturen ist steil, Resistablagerungen sind nicht mehr nachweisbar und die Resisthaftung wird verbessert.

## Patentansprüche

**1.** Verfahren zum Entwickeln positiv arbeitender Resiste, die als strahlungsempfindliche Schicht ein Gemisch aus mindestens einem phenolischen Polymeren und mindestens einem Sulfoniumsalz mit säurelabilen Gruppen enthalten, dadurch gekennzeichnet, daß die strahlungsempfindliche Schicht nach der bildmäßigen Bestrahlung mit einer wäßrigen Entwicklerlösung entwikkelt wird, die 0,3 bis 5 Gew.-% eines Tetraalkylammoniumhydroxids mit 1 bis 3 Kohlenstoffatomen in der, gegebenenfalls hydroxylsubstituierten, Alkylgruppe und 3 bis 30 Gew.-% mindestens eines Amins der allgemeinen Formel (I)

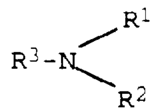 (I),

worin $R^1$, $R^2$ und $R^3$ untereinander gleich oder verschieden sind und für Wasserstoff, Alkyl mit 1 bis 3 Kohlenstoffatomen, Hydroxyalkyl mit 2 oder 3 Kohlenstoffatomen, Aminoalkyl mit 2 oder 3 Kohlenstoffatomen stehen oder zwei der Reste $R^1$ bis $R^3$ miteinander zu einem 5- bis 7-gliedrigen N-haltigen Ring verknüpft sind, mit der Maßgabe, daß mindestens einer der Reste $R^1$ bis $R^3$ Hydroxylalkyl oder Aminoalkyl ist, enthält.

**2.** Verfahren nach Anspruch 1, dadurch gekennzeichnet, daß die Entwicklerlösung zusätzlich bis zu 5 Gew.-% eines 2 oder 4 Kohlenstoffatome enthaltenden Alkohols oder eines wasserlöslichen Glykolethers enthält.

**3.** Verfahren nach einem der vorhergehenden Ansprüche, dadurch gekennzeichnet, daß die Entwicklerlösung als Amin der allgemeinen Formel (I) Diethanolamin, N-Methyldiethanolamin, Triethanolamin oder ein Aminopropanol enthält.

**4.** Verfahren nach Anspruch 1 oder 2, dadurch gekennzeichnet, daß die Entwicklerlösung als Amin der allgemeinen Formel (I) 3-Amino-1-propylamin, 3-Dimethylamino-1-propylamin oder ein N-Hydroxyalkylpiperidin enthält.

## Claims

**1.** A process for developing a positive-working resist which contains as radiation-sensitive layer a mixture of at least one phenolic polymer and at least one sulfonium salt having an acid-labile group, which comprises, following imagewise irradiation, developing the radiation-sensitive layer with an aqueous developer which comprises from 0.3 to 5 % by weight of a tetraalkylammonium hydroxide having from 1 to 3 carbon atoms in the unsubstituted or hydroxyl-substituted alkyl group and from 3 to 30 % by weight of at least one amine of the general formula (I)

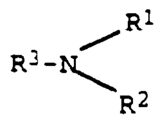 (I),

where $R^1$, $R^2$ and $R^3$ are identical or different and each is hydrogen, alkyl of from 1 to 3 carbon atoms, hydroxyalkyl of 2 or 3 carbon atoms, or aminoalkyl of 2 or 3 carbon atoms, or two of $R^1$ to $R^3$ combine to form a 5-, 6- or 7-membered N-containing ring, with the proviso that at least one of $R^1$ to $R^3$ is hydroxyalkyl or aminoalkyl.

**2.** A process as claimed in claim 1, wherein the developer additionally contains up to 5 % by weight of an alcohol of 2 or 4 carbon atoms or of a water-soluble glycol ether.

**3.** A process as claimed in either of the preceding claims, wherein the amine of the general formula (I) is diethanolamine, N-methyldiethanolamine, triethanolamine or an aminopropanol.

**4.** A process as claimed in claim 1 or 2, wherein the amine of the general formula (I) is 3-amino-1-propylamine, 3-dimethylamino-1-propylamine or an N-hydroxyalkylpiperidine.

## Revendications

**1.** Procédé de développement de photorésists positifs, qui contiennent, en tant que couche photosensible, un mélange d'au moins un polymère phénolique et d'au moins un sel de sulfonium avec des groupes partant en milieu acide, caractérisé par le fait que la couche photosensible est développée, après l'exposition de manière à former une image, à l'aide d'une solution de développement aqueuse, qui contient de 0,3 à 5 % en poids d'un hydroxyde de tétra-alkylammonium dont le groupe alkyle, qui porte éventuellement un substituant hydroxy, comprend de 1 à 3 atomes de carbone, et de 3 à 30 % en poids d'au moins une amine de formule générale (1)

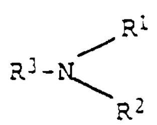 (I),

dans laquelle $R^1$, $R^2$ et $R^3$ sont identiques ou différents et représentent un atome d'hydrogène, un groupe alkyle ayant 1 à 3 atomes de carbone, un groupe hydroxyalkyle ayant 2 à 3 atomes de carbone, un groupe aminoalkyle ayant 2 ou 3 atomes de carbone, ou deux des restes $R^1$ à $R^3$ forment ensemble un cycle azoté ayant 5 à 7 maillons, étant entendu qu'au moins l'un des restes $R^1$ à $R^3$ est un groupe hydroxyalkyle ou aminoalkyle.

**2.** Procédé selon la revendication 1, caractérisé par le fait que la solution de développement contient en outre jusqu'à 5 % en poids d'un alcool ayant 2 ou 4 atomes de carbone ou d'un glycoléther hydrosoluble.

**3.** Procédé selon l'une quelconque des revendications précédentes, caractérisé par le fait que la solution de développement contient, en tant qu'amine de formule générale (1), la diéthanolamine, la N-méthyldiéthanolamine, la triéthanolamine ou un aminopropanol.

**4.** Procédé selon la revendication 1 ou 2, caractérisé par le fait que la solution de développement contient, en tant qu'amine de formule générale (1), la 3-amino-1-propylamine, la 3-diméthylamino-1-propylamine ou une N-hydroxyalkylpipéridine.